# EUROPÄISCHE PATENTSCHRIFT

(11) **EP 3 837 557 B1**
(45) Veröffentlichungstag und Bekanntmachung des Hinweises auf die Patenterteilung: **01.06.2022**
(21) Anmeldenummer: 19762090.9
(22) Anmeldetag: 07.08.2019
(51) Int. Cl.: G01R 15/20

(54) **STROMMESSGERÄT ZUM ERFASSEN EINES STROMS IN EINER ELEKTRISCHEN LEITUNG**
CURRENT MEASURING DEVICE FOR DETECTING A CURRENT IN AN ELECTRIC LINE
DISPOSITIF DE MESURE DE COURANT POUR DÉTECTER UN COURANT DANS UNE LIGNE ÉLECTRIQUE

(30) Priorität: 16.08.2018 DE 102018120009
(43) Veröffentlichungstag der Anmeldung: 23.06.2021
(73) Patentinhaber: Phoenix Contact GmbH & Co. KG, 32825 Blomberg (DE)
(72) Erfinder: JANKOWSKI, Martin, 30926 Seelze (DE)
(74) Vertreter: Maikowski & Ninnemann Patentanwälte Partnerschaft mbB
(86) Internationale Anmeldenummer: PCT/EP2019/071244
(87) Internationale Veröffentlichungsnummer: WO 2020/035372

(56) Entgegenhaltungen:
- DE-A1-102016 123 255
- US-A1- 2011 057 650

## Beschreibung

Die Erfindung betrifft ein Strommessgerät zum Erfassen eines Stroms in einer elektrischen Leitung nach dem Oberbegriff des Anspruchs 1.

Ein derartiges Strommessgerät umfasst ein Gehäuse, eine an dem Gehäuse angeordnete Befestigungseinrichtung zum Befestigen des Gehäuses an einer Tragschiene und zumindest einen Magnetfeldsensor.

Ein solches Strommessgerät kann insbesondere zum Überwachen von sogenannten Stringströmen an Solaranlagen zum Einsatz kommen. Üblicherweise sind Solarpaneele über Leitungen zum Beispiel in Reihe miteinander verschaltet, sodass zwischen den Solarpaneelen Ströme - die sogenannten Stringströme - fließen. An solchen Leitungen ist eine Erfassung der Ströme zum Zwecke einer Stringstromüberwachung wünschenswert.

Ein solches Strommessgerät kann aber auch in der Prozessindustrie oder im Bereich der E-Mobilität zum Messen von Strömen eingesetzt werden.

Ein Strommessgerät der hier in Rede stehenden Art kann an einer Tragschiene angeordnet und mit anderen elektrischen oder elektronischen Geräten in flexibler Weise kombiniert werden, um an einer Tragschiene eine Anordnung von elektrischen und/oder elektronischen Geräten zu schaffen. Ein solches Strommessgerät kann beispielsweise auch mit anderen Strommessgeräten an einer Tragschiene kombiniert werden, um einen Strom an mehreren elektrischen Leitungen zu messen.

Zum Überwachen von Stringströmen sind Strommessgeräte bekannt, die es üblicherweise erforderlich machen, elektrische Leitungen, an denen die Ströme zu erfassen sind, aufzutrennen. Dies ist umständlich und stellt zudem einen erheblichen Eingriff in das System dar.

Bei einem aus der DE 10 2014 119 276 A1 bekannten Strommessgerät können elektrische Leitungen zwischen Gehäusehälften gelegt werden, um mittels Magnetfeldsensoren ein Magnetfeld an den elektrischen Leitungen zu erfassen und daraus auf einen Stromfluss in den elektrischen Leitungen zu schließen. Zum Ansetzen des Strommessgeräts an die zu überwachenden elektrischen Leitungen ist ein Trennen der Gehäusehälften voneinander erforderlich. In angesetzter Stellung erstrecken sich die elektrischen Leitungen durch das Gehäuse des Strommessgeräts hindurch. DE 10 2016 123 255 A1 offenbart eine Vorrichtung zur Messung von einem in einem elektrischen Leiter fließenden Strom.

Aufgabe der vorliegenden Erfindung ist es, ein Strommessgerät zur Verfügung zu stellen, das in einfacher Weise das Erfassen eines Stroms an einer elektrischen Leitung ermöglicht und zusammen mit anderen elektrischen oder elektronischen Geräten an einer Tragschiene angeordnet werden kann.

Diese Aufgabe wird durch einen Gegenstand mit den Merkmalen des Anspruchs 1 gelöst.

Demnach weist das Gehäuse ein erstes Gehäuseteil und ein zweites Gehäuseteil auf, die gemeinsam eine Aufnahmeeinrichtung zum Aufnehmen einer elektrischen Leitung zwischen den Gehäuseteilen ausbilden. Die Gehäuseteile sind voneinander trennbar, um eine elektrische Leitung an das Strommessgerät anzusetzen, und können aneinander angesetzt werden, um die elektrische Leitung in der Aufnahmeeinrichtung zwischen den Gehäuseteilen aufzunehmen. Der zumindest eine Magnetfeldsensor ist zum Erfassen eines Magnetfelds an der in der Aufnahmeeinrichtung aufgenommenen elektrischen Leitung ausgebildet.

Beispielsweise kann jedes Gehäuseteil eine Aufnahmenut aufweisen, wobei die Aufnahmenuten der Gehäuseteile gemeinsam die Aufnahmeeinrichtung zum Aufnehmen der elektrischen Leitung ausbilden. Jede Aufnahmenut kann beispielsweise einen halbkreisförmigen Querschnitt aufweisen, sodass sich bei zusammengesetzten Gehäuseteilen ein Aufnahmekanal für die elektrische Leitung mit (zumindest bereichsweise) kreisförmigem Querschnitt ergibt.

Das Strommessgerät kann über seine Befestigungseinrichtung an einer Tragschiene befestigt werden. Das Gehäuse des Strommessgeräts ist hierbei durch zwei Gehäuseteile gebildet, die voneinander getrennt werden können, um eine elektrische Leitung zwischen die Gehäuseteile zu legen. Durch Zusammensetzen der Gehäuseteile wird die elektrische Leitung zwischen den Gehäuseteilen aufgenommen derart, dass über einen oder mehrere Magnetfeldsensoren ein durch die elektrische Leitung fließender Strom erfasst und (quantitativ und/oder qualitativ) ausgewertet werden kann.

Dadurch, dass das Strommessgerät an eine Tragschiene angesetzt werden kann, kann das Strommessgerät in beliebiger Weise mit anderen elektrischen und/oder elektronischen Geräten, zum Beispiel weiteren Strommessgeräten, kombiniert werden. An einer Tragschiene kann somit eine flexibel gestaltbare elektrische Anlage zum Beispiel in einem Schaltschrank geschaffen werden.

In einer Ausgestaltung weisen das erste Gehäuseteil ein oder mehrere erste Magnetfeldsensoren und/oder das zweite Gehäuseteil ein oder mehrere zweite Magnetfeldsensoren auf. Grundsätzlich ist ein einziger Magnetfeldsensor zum Erfassen eines Magnetfelds an der zu überwachenden elektrischen Leitung ausreichend. Ein solcher Magnetfeldsensor kann an dem ersten Gehäuseteil oder dem zweiten Gehäuseteil angeordnet sein. Durch Verwenden mehrerer Magnetfeldsensoren an dem ersten Gehäuseteil und/oder an dem zweiten Gehäuseteil kann die Strommessung jedoch verbessert werden, indem Störfeldeinflüsse durch externe Magnetfelder herausgerechnet werden können, was die Messgenauigkeit verbessern kann.

Beispielsweise können, in einer Ausgestaltung, an jedem Gehäuseteil zwei oder mehr Magnetfeldsensoren angeordnet sein, die gleichverteilt um die zu überwachende elektrische Leitung angeordnet sind, wenn die Gehäuseteile aneinander angesetzt sind. Die Magnetfeldsensoren sind bei zusammengefügten Gehäuseteilen in naher Lagebeziehung zu der zu überwachenden elektrischen Leitung angeordnet und um die elektrische Leitung herum gruppiert, sodass über die Magnetfeldsensoren gemeinsam ein aufgrund eines Stromflusses durch die elektrische Leitung erzeugtes magnetisches Feld erfasst werden kann, um anhand von durch die Magnetfeldsensoren erzeugten Sensorsignalen Rückschlüsse auf den Stromfluss in der elektrischen Leitung zu ziehen.

Sind Magnetfeldsensoren sowohl an dem ersten Gehäuseteil als auch an dem zweiten Gehäuseteil angeordnet, sind die Gehäuseteile vorzugsweise elektrisch über eine geeignete Steckverbindereinrichtung miteinander verbunden. Über die Steckverbindereinrichtung wird bei Ansetzen der Gehäuseteile aneinander eine elektrische Verbindung zwischen den Gehäuseteilen hergestellt, sodass Sensorsignale der Magnetfeldsensoren an eine an einem der Gehäuseteile angeordnete Steuereinrichtung geleitet werden können.

In einer Ausgestaltung weisen das erste Gehäuseteil ein erstes Flusskonzentratorteil und/oder das zweite Gehäuseteil ein zweites Flusskonzentratorteil zum Leiten eines magnetischen Flusses um die in der Aufnahmeeinrichtung aufgenommene elektrische Leitung auf. Ein solches Flusskonzentratorteil kann beispielsweise als ferromagnetischer Anker ausgebildet sein. Jedes Gehäuseteil kann hierbei ein Flusskonzentratorteil in Form eines Halbrings aufweisen, die bei aneinander angesetzten Gehäuseteilen einen geschlossenen Flusskonzentratorring in Form eines Toroiden zum ringförmigen Leiten des magnetischen Flusses um die in der Aufnahmeeinrichtung aufgenommene elektrische Leitung herum ausbilden, wobei der zumindest eine Magnetfeldsensor an dem Flusskonzentratorring angeordnet ist. Beispielsweise kann der zumindest eine Magnetfeldsensor in eines der Flusskonzentratorteile integriert sein.

Die Flusskonzentratorteile dienen zum Konzentrieren der magnetischen Flussdichte an dem zwischen den Gehäuseteilen aufgenommenen elektrischen Leiter. Die Flusskonzentratorteile, die vorzugsweise gemeinsam die Form eines Toroiden ausbilden, bündeln die Feldlinien um den Leiter und homogenisieren diese, was die Messung auch von kleinen Strömen in dem elektrischen Leiter möglich macht.

Ein oder mehrere Magnetfeldsensoren können an den Flusskonzentratorteilen in einer sogenannten Open-Loop-Konfiguration oder einer Closed-Loop-Konfiguration miteinander verschaltet sein.

In einer Ausgestaltung ist der zumindest eine Magnetfeldsensor durch einen magnetoresistiven Sensor ausgebildet. Solche magnetoresistiven Sensoren machen sich den sogenannten magnetoresistiven Effekt zunutze, infolgedessen sich der elektrische Widerstand eines Materials in Abhängigkeit von einem äußeren Magnetfeld ändert. Eine solche Widerstandsänderung kann erfasst und ausgewertet werden, um anhand der Widerstandsänderung auf die Stärke des Magnetfelds und daraus auf die Stärke des Stromflusses im elektrischen Leiter zu schließen.

Mittels solcher magnetoresistiver Sensoren können zeitlich veränderliche magnetische Wechselfelder bei einem elektrischen Wechselstrom genauso wie zeitlich unveränderliche magnetische Felder bei einem Gleichstrom in der elektrischen Leitung erfasst werden, sodass sowohl eine Wechselstromerfassung als auch eine Gleichstromerfassung an der zu überwachenden elektrischen Leitung möglich ist.

Die Befestigungseinrichtung kann beispielsweise an dem zweiten Gehäuseteil angeordnet sein. Über die Befestigungseinrichtung kann das zweite Gehäuseteil und darüber das Gehäuse des Strommessgeräts zum Beispiel formschlüssig an der Tragschiene festgelegt werden, indem das zweite Gehäuseteil mit der Tragschiene verrastet wird. In befestigter Stellung ist das Strommessgerät fest an der Tragschiene gehalten und kann an der Tragschiene beispielsweise mit anderen elektrischen oder elektronischen Geräten kombiniert werden.

In einer Ausgestaltung weist das Strommessgerät eine in dem Gehäuse eingefasste Elektronikbaugruppe mit einer Steuereinrichtung zum Auswerten von über den zumindest einen Magnetfeldsensor erhaltenen Sensorsignalen auf. Die Elektronikbaugruppe kann beispielsweise eine Leiterplatte aufweisen, an der sowohl der zumindest eine Magnetfeldsensor als auch ein elektronischer Chip zur Verwirklichung der Steuereinrichtung angeordnet sind. Der zumindest eine Magnetfeldsensor ist mit der Steuereinrichtung verbunden und leitet seine Sensorsignale der Steuereinrichtung zu, die die Sensorsignale auswertet, um anhand der Sensorsignale auf einen Stromfluss in der an das Strommessgerät angesetzten elektrischen Leitung zu schließen.

Die Elektronikbaugruppe kann beispielsweise an dem ersten Gehäuseteil angeordnet sein. Ist die Befestigungseinrichtung an dem zweiten Gehäuseteil angeordnet, ergibt sich somit eine Ausgestaltung des Gehäuses, bei dem die Gehäuseteile funktional unterschiedlich ausgestaltet sind. Über die Elektronikbaugruppe des ersten Gehäuseteils werden elektrische und elektronische Funktionen, insbesondere Steuerungs- und Auswertefunktionen, an dem Strommessgerät übernommen. Über die Befestigungseinrichtung an dem zweiten Gehäuseteil kann das Strommessgerät mechanisch an einer Tragschiene befestigt werden.

Das Strommessgerät weist eine Kalibrierbaugruppe auf, die einen mit einem Prüfstrom beaufschlagbaren Prüfleiter aufweist, der derart zu dem zumindest einen Magnetfeldsensor in dem Gehäuse angeordnet ist, dass anhand eines Prüfstroms eine Auswertung eines erfassten Magnetfelds kalibrierbar ist. Beispielsweise gesteuert durch die Steuereinrichtung kann ein Prüfstrom beispielsweise durch eine steuerbare Stromquelle erzeugt werden, sodass durch den Prüfleiter ein definierter Strom geleitet wird. Der Prüfleiter ist hierbei in definierter Lagebeziehung zu dem zumindest einem Magnetfeldsensor angeordnet, sodass an einem oder an mehreren Magnetfeldsensoren aufgrund des Prüfstroms ein Magnetfeld erfasst wird. Aufgrund des bekannten Prüfstroms und der bekannten Lagebeziehung des Prüfleiters zu dem zumindest einen Magnetfeldsensor kann über die so erfassten Magnetfelder eine Kalibrierung durchgeführt werden, um aus den über den zumindest einen Magnetfeldsensor erfassten Sensorsignalen den in einer elektrischen Leitung fließenden Strom zu bestimmen.

Einem jeden Magnetfeldsensor einer Anordnung von Magnetfeldsensoren kann hierbei ein Prüfleiter zugeordnet sein, sodass die Magnetfeldsensoren einzeln kalibriert und auf ihre Funktionstüchtigkeit geprüft werden können. Denkbar ist aber auch, lediglich einem Magnetfeldsensor einen Prüfleiter zuzuordnen, um anhand des einen Prüfleiters das Strommessgerät insgesamt zu kalibrieren.

Der Prüfleiter kann beispielsweise als gesonderter, zum Beispiel elektrisch isolierter Leiter ausgebildet sein, der in definierter Lagebeziehung zu einem zugeordneten Magnetfeldsensor angeordnet ist. Denkbar und möglich ist aber auch, einen Prüfleiter zum Beispiel durch eine Leiterbahn auf einer Leiterplatte auszubilden.

In einer Ausgestaltung weist das Strommessgerät eine Anschlusseinrichtung zum Anschließen einer Leitung zum Bereitstellen einer elektrischen Versorgung und/oder zum Übertragen von Datensignalen auf. Über die Anschlusseinrichtung kann das Strommessgerät beispielsweise elektrisch gespeist werden, um die in dem Gehäuse eingefasste Elektronikbaugruppe elektrisch zu versorgen. Über die Anschlusseinrichtung können hierbei auch Datensignale - zum Beispiel Messwerte, die durch die elektrischen Leitungen fließende Ströme angeben - oder analoge Normsignale in einem Bereich von zum Beispiel 0/4 bis 20 mA oder -20 mA bis 20 mA oder Spannungssignale in einem Bereich zum Beispiel von 0 bis 10 V, 0 bis 5 V, -10 V bis + 10 V usw. an eine übergeordnete Baugruppe übertragen werden.

Ist die Anschlusseinrichtung als Datenanschluss ausgebildet, kann die Anschlusseinrichtung beispielsweise als USB-Schnittstelle, als RS485-Anschluss, als Ethernet-Anschluss oder als andere serielle Schnittstelle ausgestaltet sein. Denkbar und möglich ist in einer vorteilhaften Ausgestaltung, dass über die Anschlusseinrichtung sowohl eine elektrische Versorgung als auch eine Datenübertragung erfolgen kann.

Die Anschlusseinrichtung ist beispielsweise an dem ersten Gehäuseteil angeordnet, an dem auch die Elektronikbaugruppe angeordnet ist. Über die Anschlusseinrichtung können somit ein oder mehrere elektrische Zuleitungen an die Elektronikbaugruppe angeschlossen werden.

Der der Erfindung zugrunde liegende Gedanke soll nachfolgend anhand der in den Figuren dargestellten Ausführungsbeispiele näher erläutert werden. Es zeigen:
- Fig. 1: eine Ansicht eines Strommessgeräts an einer Tragschiene;
- Fig. 2: eine Ansicht eines Ausführungsbeispiels eines Strommessgeräts, mit voneinander getrennten Gehäuseteilen;
- Fig. 3: eine Ansicht eines anderen Ausführungsbeispiels eines Strommessgeräts, mit voneinander getrennten Gehäuseteilen;
- Fig. 4: eine Ansicht des Strommessgeräts gemäß Fig. 3, darstellend eine Elektronikbaugruppe zum Auswerten von über einen Magnetfeldsensor erhaltenen Sensorsignalen;
- Fig. 5: eine Ansicht eines Ausführungsbeispiels von um eine elektrische Leitung gruppierten Magnetfeldsensoren;
- Fig. 6: eine Ansicht einer Anordnung von Strommessgeräten an einer Tragschiene;
- Fig. 7: eine schematische Ansicht eines Prinzipschaltbilds eines Ausführungsbeispiels eines Strommessgeräts; und
- Fig. 8: eine Ansicht einer Anordnung eines Prüfleiters einer Kalibrierbaugruppe relativ zu einem Magnetfeldsensor.

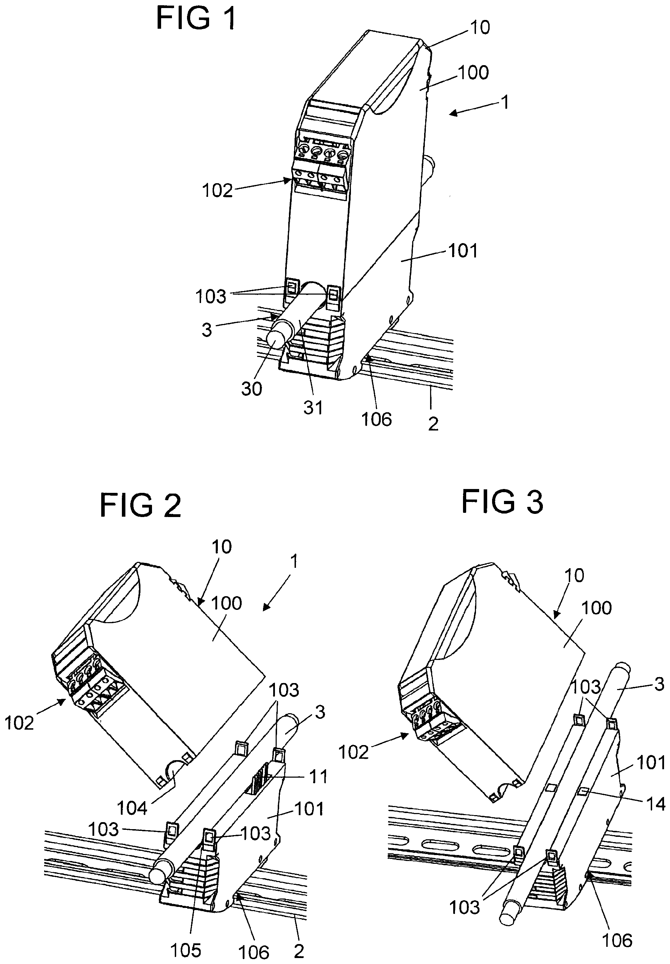

Fig. 1 zeigt ein Ausführungsbeispiel eines Strommessgeräts 1, das ein aus zwei Gehäuseteilen 100, 101 zusammengesetztes Gehäuse 10 aufweist und an einer Tragschiene 2, gegebenenfalls in Kombination mit anderen elektrischen oder elektronischen Geräten, angeordnet werden kann. Das Strommessgerät 1 dient zum Messen eines Stromflusses durch eine zwischen den Gehäuseteilen 100, 101 aufgenommene elektrische Leitung 3.

Wie aus Fig. 2 und 3 ersichtlich ist, weisen die Gehäuseteile 100, 101 des Gehäuses 10 des Strommessgeräts 1 jeweils eine Aufnahmenut 104, 105 auf, die gemeinsam eine Aufnahmeeinrichtung zum Aufnehmen der elektrischen Leitung 3 zwischen den Gehäuseteilen 100, 101 ausbilden. Die Gehäuseteile 100, 101 können zusammengefügt werden, um in einer aneinander angesetzten Stellung die elektrische Leitung 3 zwischen den Gehäuseteilen 100, 101 einzufassen und festzulegen und einen Stromfluss durch die elektrische Leitung 3 zu überwachen.

Die Gehäuseteile 100, 101 sind in aneinander angesetzter Stellung über eine Rastverbindung 103 lösbar miteinander verbunden. Die Gehäuseteile 100, 101 können voneinander getrennt werden, um die elektrische Leitung 3 wieder von dem Strommessgerät 1 zu entnehmen und gegebenenfalls eine andere elektrische Leitung 3 zwischen die Gehäuseteile 100, 101 zu legen.

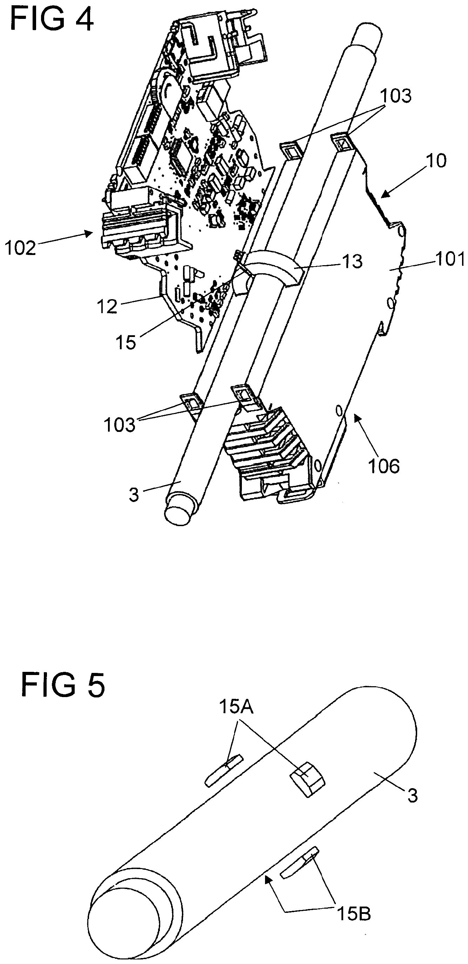

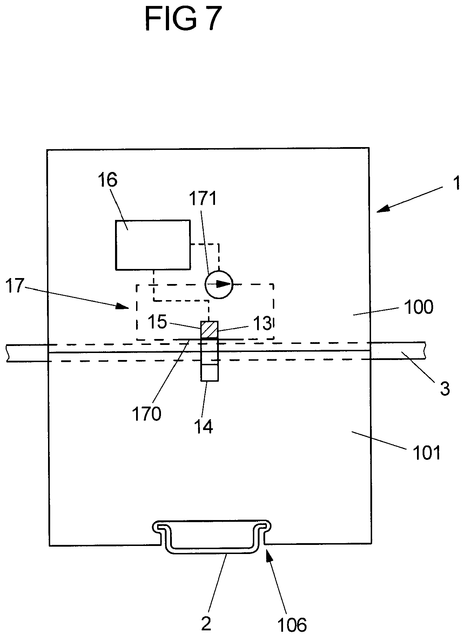

Zumindest eines der Gehäuseteile 100, 101 weist einen Magnetfeldsensor 15, 15A, 15B (siehe Fig. 4 und 5) auf, der dazu dient, ein Magnetfeld an einer zwischen den Gehäuseteilen 100, 101 aufgenommenen elektrischen Leitung 3 zu erfassen und erzeugte Sensorsignale einer Steuereinrichtung 16 (siehe Fig. 7) zuzuleiten, um anhand der Sensorsignale Rückschlüsse auf den durch die elektrische Leitung 3 fließenden Strom zu ziehen.

Unterschiedliche Ausgestaltungen des Strommessgeräts 1 sind denkbar und möglich.

Beispielsweise können an jedem Gehäuseteil 100, 101 Magnetfeldsensoren 15A, 15B angeordnet sein, wie dies bei dem Ausführungsbeispiel gemäß Fig. 5 verwirklicht ist. An dem ersten Gehäuseteil 100 sind in diesem Fall Magnetfeldsensoren 15A angeordnet, während an dem zweiten Gehäuseteil 101 Magnetfeldsensoren 15B angebracht sind. Bei aneinander angesetzten Gehäuseteilen 100, 101 sind die Magnetfeldsensoren 15A, 15B zueinander gruppiert und gleichverteilt um die zu überwachende elektrischen Leitung 3 angeordnet derart, dass über die Magnetfeldsensoren 15A, 15B das Magnetfeld an der elektrischen Leitung 3 erfasst werden kann, um anhand von durch die Magnetfeldsensoren 15A, 15B erzeugten Sensorsignalen Rückschlüsse auf den Strom in der elektrischen Leitung 3 zu ziehen.

Sind an jedem Gehäuseteil 100, 101 Magnetfeldsensoren 15A, 15B angeordnet, so sind die Gehäuseteile 100, 101 in aneinander angesetzter Stellung vorzugsweise über eine elektrische Steckverbindereinrichtung 11, wie sie in Fig. 2 dargestellt ist, elektrisch miteinander verbunden, sodass über die Steckverbindereinrichtung 11 zum Beispiel Sensorsignale der Magnetfeldsensoren 15B des zweiten Gehäuseteils 101 hin zu der Steuereinrichtung 16 an dem ersten Gehäuseteil 100 geleitet werden können.

In anderer Ausgestaltung ist nur an dem ersten Gehäuseteil 100 ein Magnetfeldsensor 15 angeordnet, wie dies in Fig. 4 dargestellt ist, wobei bei diesem Ausführungsbeispiel das erste Gehäuseteil 100 und das zweite Gehäuseteil 101 jeweils ein Flusskonzentratorteil 13, 14 in Form eines Halbrings aufweisen, die bei aneinander angesetzten Gehäuseteilen 100, 101 zu einem umlaufenden Flusskonzentratorring in Form eines Toroiden zusammengefügt sind.

Ein solcher Flusskonzentratorring dient zum Konzentrieren des magnetischen Flusses um die elektrische Leitung 3. Wie aus Fig. 4 ersichtlich, ist der durch die Flusskonzentratorteile 13, 14 gebildete Flusskonzentratorring hierbei durch einen Magnetfeldsensor 15 auf Seiten des ersten Gehäuseteils 100 unterbrochen, sodass durch den Magnetfeldsensor 15 der durch den Flusskonzentratorring geleitete magnetische Fluss detektiert werden kann.

Bei dem Ausführungsbeispiel gemäß Fig. 3 und 4 ist das zweite Gehäuseteil 101 mit Blick auf die Strommessung passiv. Eine Steckverbindereinrichtung 11 zum elektrischen Verbinden der Gehäuseteile 100, 101 miteinander ist in diesem Fall nicht erforderlich.

Die Magnetfeldsensoren 15, 15A, 15B können beispielsweise durch magnetoresistive Sensoren ausgebildet sein. Magnetfeldsensoren 15, 15A, 15B in Form magnetoresistiver Sensoren weisen einen elektrischen Widerstand auf, der abhängig vom durch die elektrische Leitung 3 erzeugten Magnetfeld veränderlich ist. Die Magnetfeldsensoren 15, 15A, 15B sind über Anschlussleitungen an eine Elektronikbaugruppe 12, insbesondere eine Leiterplatte, angeschlossen derart, dass über die Magnetfeldsensoren 15, 15A, 15B Sensorsignale, die von dem an der elektrischen Leitung 3 bestehenden Magnetfeld abhängen, erhalten und ausgewertet werden können, um anhand der Sensorsignale Rückschlüsse auf einen durch die elektrische Leitung 3 fließenden Strom zu ziehen.

Die elektrische Leitung 3 weist eine von einem elektrisch isolierenden Mantel 31 umgebende Leitungsader 30 auf, durch die im Betrieb der übergeordneten elektrischen Anlage, mit dem die Leitung 3 verbunden ist, ein Strom fließt. Aufgrund des Stromflusses ergibt sich an der elektrischen Leitung 3 ein Magnetfeld, das die elektrische Leitung 3 zirkular umgibt und auch die Magnetfeldsensoren 15, 15A, 15B durchdringt und an den Magnetfeldsensoren 15, 15A, 15B aufgrund des magnetoresistiven Effekts einen Einfluss auf den elektrischen Widerstand hat. Anhand zum Beispiel eines Spannungsabfalls an den Magnetfeldsensoren 15, 15A, 15B kann somit auf die Feldstärke des Magnetfeldes um die elektrische Leitung 3 geschlossen werden, um daraus Rückschlüsse auf den Stromfluss durch die elektrische Leitung 3 zu ziehen.

Wie aus dem Prinzipschaltbild gemäß Fig. 7 ersichtlich, weist das Strommessgerät 1 in einem Ausführungsbeispiel eine Steuereinrichtung 16 zum Beispiel in Form eines auf einer Leiterplatte angeordneten Prozessors auf, mit der die den unterschiedlichen Aufnahmenuten 100 zugeordneten Magnetfeldsensoren 15, 15A, 15B verbunden sind. Die Steuereinrichtung 16 dient dazu, über die Magnetfeldsensoren 15, 15A, 15B erhaltene Sensorsignale auszuwerten, um Rückschlüsse auf einen Strom an einer zu überwachenden elektrischen Leitung 3 zu ziehen.

Eine Bestimmung der Stromstärke in einer elektrischen Leitung 3 anhand erhaltener Sensorsignale kann zum Beispiel auf Grundlage einer Kalibrierung erfolgen. Zum Zwecke der Kalibrierung kann das Strommessgerät 1, wie bei dem Ausführungsbeispiel gemäß Fig. 7, zum Beispiel eine Kalibrierbaugruppe 17 aufweisen, die es ermöglicht, eine Selbstkalibrierung des Strommessgeräts 1 durchzuführen. Eine solche Selbstkalibrierung kann vor Inbetriebnahme genauso wie im laufenden Betrieb durchgeführt werden, um das Strommessgerät 1 vor Inbetriebnahme und im Betrieb zu kalibrieren.

Die Kalibrierbaugruppe 17 weist einen Prüfleiter 170 auf, der in definierter Lagebeziehung zu einem zugeordneten Magnetfeldsensor 15 angeordnet ist und sich beispielsweise durch die Flusskonzentratorteile 13, 14 hindurcherstreckt, sodass anhand eines Stromflusses durch den Prüfleiter 170 eine Kalibrierung vorgenommen werden kann, die einen Rückschluss auf die Stromstärke in einer elektrischen Leitung 3 an dem Strommessgerät 1 erlaubt.

Der Prüfleiter 170 ist mit einer über die Steuereinrichtung 16 steuerbaren Stromquelle 171 verbunden, mittels derer ein definierter Strom durch den Prüfleiter 170 geleitet werden kann. Anhand des definierten Stroms und der über den Magnetfeldsensor 15 aufgenommenen Sensorsignale kann unter Einbeziehung der Lagebeziehung des Prüfleiters 170 zu dem zugeordneten Magnetfeldsensor 15 und den Flusskonzentratorteilen 13, 14 eine Kalibrierung durchgeführt werden, die Stromwerte in Beziehung setzt zu erfassten magnetfeldabhängigen Sensorsignalen, sodass zum Beispiel eine Kalibrierungstabelle erstellt werden kann, auf Basis derer im eigentlichen Betrieb die Stromstärke eines in einer elektrischen Leitung 3 fließenden Stroms anhand der über den zumindest einen Magnetfeldsensor 15, 15A, 15B erfassten Sensorsignale bestimmt werden kann.

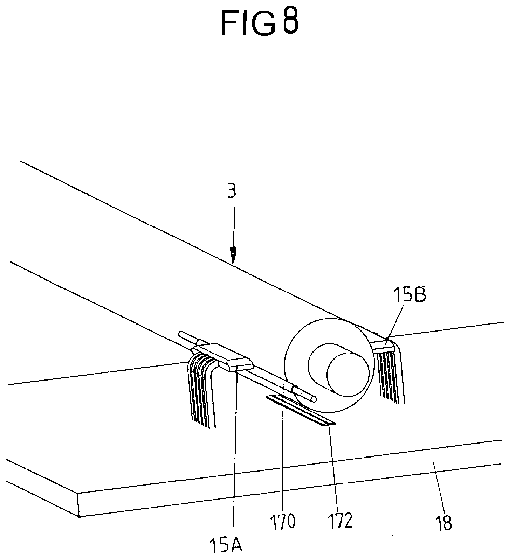

Wie in dem Ausführungsbeispiel gemäß Fig. 8 ersichtlich, kann der Prüfleiter 170 als isolierte elektrische Leitung ausgebildet sein, mit einer in einem Kabelmantel eingefassten Leitungsader, die sich entlang der Längserstreckungsrichtung, entlang der eine Leitung 3 an dem Gehäuse 10 aufgenommen ist, erstreckt und die in definierter Lagebeziehung zu einem zugeordneten Magnetfeldsensor 15A, 15B angeordnet ist.

Zusätzlich oder alternativ kann ein Prüfleiter 172 auch durch eine Leiterbahn auf einer Leiterplatte 18, an der auch andere elektrische und elektronische Komponenten des Strommessgeräts 1 angeordnet sind (insbesondere die Magnetfeldsensoren 15, 15B und die Steuereinrichtung 16), ausgebildet sein.

Jeweils steht der Prüfleiter 170, 172 mit einer Stromquelle 171 zum Einleiten eines Prüfstroms in Verbindung.

Das Strommessgerät 1 weist eine Anschlusseinrichtung 102 an dem ersten Gehäuseteil 100 auf, über die eine Zuleitungen an das Strommessgerät 1 angeschlossen werden kann, um an dem Strommessgerät 1 eine elektrische Versorgung bereitzustellen und/oder Daten hin zu dem Strommessgerät 1 oder von dem Strommessgerät 1 hin zu einer übergeordneten Baugruppe zu übertragen.

Ist die Anschlusseinrichtung 102 für eine Datenübertragung ausgelegt, kann die Anschlusseinrichtung 102 beispielsweise durch eine USB-Schnittstelle, eine RS485-Schnittstelle oder eine Ethernet-Schnittstelle verwirklicht sein.

In einer vorteilhaften Ausgestaltung ist die Anschlusseinrichtung 102 für die Bereitstellung einer elektrischen Versorgung an dem Strommessgerät 1 und zudem für eine Datenübertragung ausgelegt.

Bei den dargestellten Ausführungsbeispielen ist in dem ersten Gehäuseteil 100, wie aus Fig. 4 ersichtlich, eine Elektronikbaugruppe 12 eingefasst, deren Bestandteil die Steuereinrichtung 16 ist und mit der auch die Anschlusseinrichtung 102 in Verbindung steht. Die Elektronikbaugruppe 12 weist insbesondere eine Leiterplatte auf, an der elektrische und elektronische Komponenten angeordnet sind. Die Steuereinrichtung 16 kann beispielsweise durch einen elektronischen Chip an der Leiterplatte verwirklicht sein.

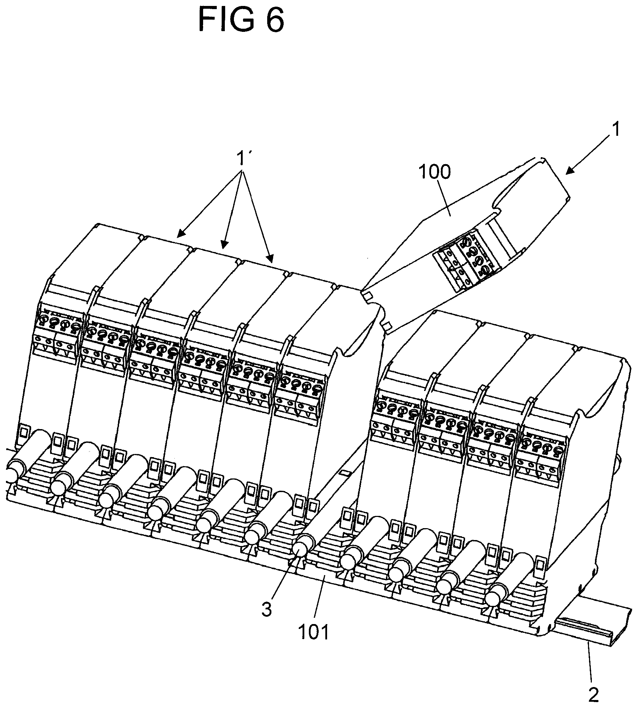

An dem zweiten Gehäuseteil 101 ist, an einer dem ersten Gehäuseteil 100 abgewandten Seite, eine Befestigungseinrichtung 106 zum rastenden Befestigen des Strommessgeräts 1 an einer Tragschiene 2 angeordnet. An der Tragschiene 2 kann das Strommessgerät 1, wie dies in Fig. 6 dargestellt ist, mit anderen elektrischen oder elektronischen Geräten, zum Beispiel anderen Strommessgeräten 1', kombiniert werden, um eine elektrische Anlage an einer Tragschiene 2 zum Beispiel in einem Schaltschrank zu schaffen.

Der der Erfindung zugrunde liegende Gedanke ist nicht auf die vorangehend geschilderten Ausführungsbeispiele beschränkt, sondern lässt sich auch in gänzlich andersgearteter Weise verwirklichen.

Ein Strommessgerät der beschriebenen Art ist insbesondere nicht nur für die Überwachung von Stringströmen an Solaranlagen geeignet, sondern kann prinzipiell zur Strommessung an ganz unterschiedlichen elektrischen Anlagen, zum Beispiel in der Prozesstechnik oder im Bereich der E-Mobilität, zum Einsatz kommen.

### Bezugszeichenliste

- 1, 1': Strommessgerät
- 10: Gehäuse
- 100, 101: Gehäuseteil
- 102: Anschlusseinrichtung
- 103: Rastverbindung
- 104, 105: Aufnahmeeinrichtung (Aufnahmenut)
- 106: Befestigungseinrichtung
- 11: Steckverbindereinrichtung
- 12: Elektronikbaugruppe (Leiterplatte)
- 13, 14: Flusskonzentratorteil
- 15, 15A, 15B: Magnetfeldsensor
- 16: Steuereinrichtung
- 17: Kalibrierbaugruppe
- 170: Prüfleiter
- 171: Stromquelle
- 172: Prüfleiter
- 18: Leiterplatte
- 2: Tragschiene
- 20: Anschluss
- 3: Leitungen

## Patentansprüche

1. Strommessgerät (1) zum Erfassen eines Stroms in einer elektrischen Leitung (3), mit einem Gehäuse (10), einer an dem Gehäuse (10) angeordneten Befestigungseinrichtung (106) zum Befestigen des Gehäuses (10) an einer Tragschiene (2) und zumindest einem Magnetfeldsensor (15, 15A, 15B), wobei das Gehäuse (10) ein erstes Gehäuseteil (100) und ein zweites Gehäuseteil (101) aufweist, die gemeinsam eine Aufnahmeeinrichtung (104, 105) zum Aufnehmen einer elektrischen Leitung (3) zwischen den Gehäuseteilen (100, 101) ausbilden, wobei die Gehäuseteile (100, 101) voneinander trennbar sind, um eine elektrische Leitung (3) an das Strommessgerät (1) anzusetzen, und aneinander ansetzbar sind, um die elektrische Leitung (3) in der Aufnahmeeinrichtung (104, 105) zwischen den Gehäuseteilen (100, 101) aufzunehmen, wobei der zumindest eine Magnetfeldsensor (15, 15A, 15B) zum Erfassen eines Magnetfelds an der in der Aufnahmeeinrichtung (104, 105) aufgenommenen elektrischen Leitung (3) ausgebildet ist,
**gekennzeichnet durch**
eine Kalibrierbaugruppe (17), die einen mit einem Prüfstrom beaufschlagbaren Prüfleiter (170, 172) aufweist, der derart zu dem zumindest einen Magnetfeldsensor (15, 15A, 15B) in dem Gehäuse (10) angeordnet ist, dass anhand eines Prüfstroms eine Auswertung eines erfassten Magnetfelds kalibrierbar ist.

2. Strommessgerät (1) nach Anspruch 1, **dadurch gekennzeichnet, dass** das erste Gehäuseteil (100) zumindest einen ersten Magnetfeldsensor (15A) und/oder das zweite Gehäuseteil (101) zumindest einen zweiten Magnetfeldsensor (15B) aufweisen.

3. Strommessgerät (1) nach Anspruch 1 oder 2, **gekennzeichnet durch** eine elektrische Steckverbindereinrichtung (11) zum elektrischen Verbinden der Gehäuseteile (100, 101) miteinander.

4. Strommessgerät (1) nach einem der Ansprüche 1 bis 3, **dadurch gekennzeichnet, dass** das erste Gehäuseteil (100) ein erstes Flusskonzentratorteil (13) und/oder das zweite Gehäuseteil (101) ein zweites Flusskonzentratorteil (14) zum Leiten eines magnetischen Flusses an der in der Aufnahmeeinrichtung (104, 105) aufgenommenen elektrischen Leitung (3) aufweisen.

5. Strommessgerät (1) nach Anspruch 4, **dadurch gekennzeichnet, dass** das erste Flusskonzentratorteil (13) des ersten Gehäuseteils (100) und das zweite Flusskonzentratorteil (14) des zweiten Gehäuseteils (101) bei aneinander angesetzten Gehäuseteilen (100, 101) zu einem Flusskonzentratorring zusammengefügt sind, wobei der zumindest eine Magnetfeldsensor (15, 15A, 15B) an dem Flusskonzentratorring angeordnet ist.

6. Strommessgerät (1) nach einem der vorangehenden Ansprüche, **dadurch gekennzeichnet, dass** der zumindest eine Magnetfeldsensor (15, 15A, 15B) durch einen magnetoresistiven Sensor ausgebildet sind.

7. Strommessgerät (1) nach einem der vorangehenden Ansprüche, **dadurch gekennzeichnet, dass** die Befestigungseinrichtung (106) an dem zweiten Gehäuseteil (101) angeordnet ist.

8. Strommessgerät (1) nach einem der vorangehenden Ansprüche, **gekennzeichnet durch** eine in dem Gehäuse (10) eingefasste Elektronikbaugruppe (12) mit einer Steuereinrichtung (16) zum Auswerten von über den zumindest einen Magnetfeldsensor (15, 15A, 15B) erhaltenen Sensorsignalen.

9. Strommessgerät (1) nach Anspruch 8, **dadurch gekennzeichnet, dass** die Elektronikbaugruppe (12) an dem ersten Gehäuseteil (100) angeordnet ist.

10. Strommessgerät (1) nach einem der vorangehenden Ansprüche, **gekennzeichnet durch** eine Anschlusseinrichtung (102) zum Anschließen einer Leitung (2) zum Bereitstellen einer elektrischen Versorgung und/oder zum Übertragen von Datensignalen.

11. Strommessgerät (1) nach Anspruch 10, **dadurch gekennzeichnet, dass** die Anschlusseinrichtung (102) an dem ersten Gehäuseteil (100) angeordnet ist.

## Claims

1. Current measuring device (1) for detecting a current in an electric line (3), having a housing (10), a fastening device (106) which is arranged on the housing (10) and is intended to fasten the housing (10) to a supporting rail (2), and at least one magnetic field sensor (15, 15A, 15B), wherein the housing (10) has a first housing part (100) and a second housing part (101) which together form an accommodating device (104, 105) for accommodating an electric line (3) between the housing parts (100, 101), wherein the housing parts (100, 101) can be separated from one another in order to place an electric line (3) onto the current measuring device (1) and can be placed onto one another in order to accommodate the electric line (3) in the accommodating device (104, 105) between the housing parts (100, 101), wherein the at least one magnetic field sensor (15, 15A, 15B) is designed to detect a magnetic field on the electric line (3) accommodated in the accommodating device (104, 105),
**characterized by**
a calibration assembly (17) having a test conductor (170, 172) to which a test current can be applied and which is arranged in the housing (10) with respect to the at least one magnetic field sensor (15, 15A, 15B) in such a manner that an evaluation of a detected magnetic field can be calibrated on the basis of a test current.

2. Current measuring device (1) according to Claim 1, **characterized in that** the first housing part (100) has at least one first magnetic field sensor (15A) and/or the second housing part (101) has at least one second magnetic field sensor (15B).

3. Current measuring device (1) according to Claim 1 or 2, **characterized by** an electric plug connector device (11) for electrically connecting the housing parts (100, 101) to one another.

4. Current measuring device (1) according to one of Claims 1 to 3, **characterized in that** the first housing part (100) has a first flux concentrator part (13) and/or the second housing part (101) has a second flux concentrator part (14) for guiding a magnetic flux on the electric line (3) accommodated in the accommodating device (104, 105).

5. Current measuring device (1) according to Claim 4, **characterized in that** the first flux concentrator part (13) of the first housing part (100) and the second flux concentrator part (14) of the second housing part (101) are joined to form a flux concentrator ring when the housing parts (100, 101) have been placed onto one another, wherein the at least one magnetic field sensor (15, 15A, 15B) is arranged on the flux concentrator ring.

6. Current measuring device (1) according to one of the preceding claims, **characterized in that** the at least one magnetic field sensor (15, 15A, 15B) is formed by a magnetoresistive sensor.

7. Current measuring device (1) according to one of the preceding claims, **characterized in that** the fastening device (106) is arranged on the second housing part (101).

8. Current measuring device (1) according to one of the preceding claims, **characterized by** an electronic assembly (12) which is enclosed in the housing (10) and has a control device (16) for evaluating sensor signals received via the at least one magnetic field sensor (15, 15A, 15B).

9. Current measuring device (1) according to Claim 8, **characterized in that** the electronic assembly (12) is arranged on the first housing part (100).

10. Current measuring device (1) according to one of the preceding claims, **characterized by** a connection device (102) for connecting a line (2) for providing an electric supply and/or for transmitting data signals.

11. Current measuring device (1) according to Claim 10, **characterized in that** the connection device (102) is arranged on the first housing part (100).

## Revendications

1. Appareil de mesure de courant (1) pour détecter un courant dans une ligne électrique (3), comprenant un boîtier (10), un dispositif de fixation (106) disposé sur le boîtier (10) pour fixer le boîtier (10) à un rail porteur (2), et au moins un capteur de champ magnétique (15, 15A, 15B), le boîtier (10) présentant une première partie de boîtier (100) et une deuxième partie de boîtier (101) qui réalisent ensemble un dispositif de réception (104, 105) pour recevoir une ligne électrique (3) entre les parties de boîtier (100, 101), les parties de boîtier (100, 101) pouvant être séparées l'une de l'autre afin de connecter une ligne électrique (3) à l'appareil de mesure de courant (1), et pouvant être connectées l'une à l'autre afin de recevoir la ligne électrique (3) dans le dispositif de réception (104, 105) entre les parties de boîtier (100, 101), ledit au moins un capteur de champ magnétique (15, 15A, 15B) étant réalisé pour détecter un champ magnétique au niveau de la ligne électrique (3) reçue dans le dispositif de réception (104, 105),
**caractérisé par** un module d'étalonnage (17) qui présente un conducteur d'essai (170, 172) pouvant être sollicité par un courant d'essai et qui est disposé dans le boîtier (10) par rapport audit au moins un capteur de champ magnétique (15, 15A, 15B) de telle sorte qu'un courant d'essai permet d'étalonner une évaluation d'un champ magnétique détecté.

2. Appareil de mesure de courant (1) selon la revendication 1, **caractérisé en ce que** la première partie de boîtier (100) présente au moins un premier capteur de champ magnétique (15A), et/ou la deuxième partie de boîtier (101) présente au moins un deuxième capteur de champ magnétique (15B).

3. Appareil de mesure de courant (1) selon la revendication 1 ou 2, **caractérisé par** un dispositif de connexion enfichable électrique (11) servant à relier électriquement les parties de boîtier (100, 101) l'une à l'autre.

4. Appareil de mesure de courant (1) selon l'une quelconque des revendications 1 à 3, **caractérisé en ce que** la première partie de boîtier (100) présente une première partie de concentrateur de flux (13), et/ou la deuxième partie de boîtier (101) présente une deuxième partie de concentrateur de flux (14) servant à conduite un flux magnétique au niveau de la ligne électrique (3) reçue dans le dispositif de réception (104, 105).

5. Appareil de mesure de courant (1) selon la revendication 4, **caractérisé en ce que** la première partie de concentrateur de flux (13) de la première partie de boîtier (100) et la deuxième partie de concentrateur de flux (14) de la deuxième partie de boîtier (101) sont assemblées en un anneau concentrateur de flux dans le cas de parties de boîtier (100, 101) connectées l'une à l'autre, ledit au moins un capteur de champ magnétique (15, 15A, 15B) étant disposé au niveau de l'anneau concentrateur de flux.

6. Appareil de mesure de courant (1) selon l'une quelconque des revendications précédentes, **caractérisé en ce que** ledit au moins un capteur de champ magnétique (15, 15A, 15B) est réalisé par un capteur magnétorésistif.

7. Appareil de mesure de courant (1) selon l'une quelconque des revendications précédentes, **caractérisé en ce que** le dispositif de fixation (106) est disposé au niveau de la deuxième partie de boîtier (101).

8. Appareil de mesure de courant (1) selon l'une quelconque des revendications précédentes, **caractérisé par** un module électronique (12) enfermé dans le boîtier (10) et comprenant un dispositif de commande (16) servant à évaluer des signaux de capteur obtenus par l'intermédiaire du au moins un capteur de champ magnétique (15, 15A, 15B).

9. Appareil de mesure de courant (1) selon la revendication 8, **caractérisé en ce que** le module électronique (12) est disposé au niveau de la première partie de boîtier (100).

10. Appareil de mesure de courant (1) selon l'une quelconque des revendications précédentes, **caractérisé par** un dispositif de raccordement (102) pour raccorder une ligne (2) servant à fournir une alimentation électrique et/ou à transmettre des signaux de données.

11. Appareil de mesure de courant (1) selon la revendication 10, **caractérisé en ce que** le dispositif de raccordement (102) est disposé au niveau de la première partie de boîtier (100).
